# EUROPEAN PATENT APPLICATION

(11) **EP 1 971 194 A2**
(43) Date of publication of application: **17.09.2008**
(21) Application number: 08152800.2
(22) Date of filing: 14.03.2008
(51) Int. Cl.: H05K 3/40

(54) **Wiring substrate and manufacturing method thereof**

(30) Priority: 14.03.2007 JP 2007065766
(71) Applicant: Shinko Electric Industries Co., Ltd., Nagano-shi, Nagano 381-2287 (JP)
(72) Inventor: Muramatsu, Shigetsugu, Shinko Electronics Industries Co., Ltd., Nagano, Nagano 381-2287 (JP); Kusama, Yasuhiko Shinko Electronics Industries Co., Ltd., Nagano, Nagano 381-2287 (JP)
(74) Representative: Zimmermann & Partner

(57) **Abstract**

In a wiring substrate, a wiring pattern (40) is formed on a substrate (30). An insulating layer (60) covers the substrate (30). A connection part (40c) of the wiring pattern (40) is exposed from the insulating layer (60). A pedestal (12) for mark is formed on the substrate (30). An alignment mark (20) is formed on a top part (12b) of the pedestal (12) for mark. The alignment mark (20) is formed in a shape in which a length of a horizontal direction and a length of a vertical direction are respectively longer than a length of a horizontal direction and a length of a vertical direction of the top part (12b) of the pedestal (12) for mark and a shape in which an area present in the top part (12b) of the pedestal (12) for mark is smaller than an area of the top part (12b) of the pedestal (12) for mark. An upper surface part of the alignment mark (20) is exposed from the insulating layer (60).

## Description

This application claims priority to Japanese Patent Application No. 2007-065766, filed March 14, 2007, in the Japanese Patent Office. The priority application is incorporated by reference in its entirety.

### TECHNICAL FIELD

The present disclosure relates to a wiring substrate and a manufacturing method thereof, and more particularly to a wiring substrate characterized by a structure of electrical connection between wiring layers and a manufacturing method thereof.

### RELATED ART

Various techniques of a wiring substrate equipped with a semiconductor element by flip chip bonding and a manufacturing method of the wiring substrate have been proposed (see Patent Reference 1 and Patent Reference 2).

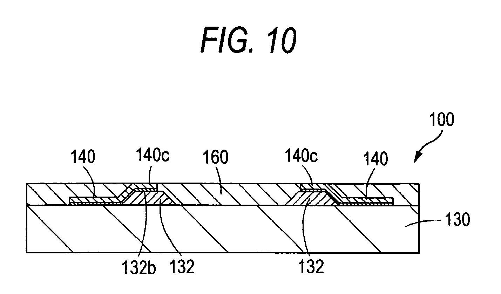

Also, an example of a wiring substrate for flip chip mounting has been proposed by applicants of the present application. In the wiring substrate, a pad for mounting is buried in a resin so as to become the same height as a substrate surface in order to improve properties of insulation between wirings and improve filling properties of an underfill resin at the time of mounting (see Fig. 10). In the wiring substrate 100, a wiring pattern 140 and a protrusion part 132 are formed on a surface of a core substrate 130. The wiring pattern 140 extends on a top part 132b of the protrusion part 132. A surface, on which the wiring pattern 140 is formed, of the core substrate 130 is covered with an insulating layer 160. A surface of a connection part 140c of the wiring pattern 140 formed on the top part 132b of the protrusion part 132 is formed with the surface of the connection part 140c exposed from a surface of the insulating layer 160. In addition, the wiring substrate is used for wire bonding mounting as well as flip chip mounting, and is also used as a multilayer wiring substrate by stack.

[Patent Reference 1] Japanese Patent Application Publication No. 2004-327721

[Patent Reference 2] Japanese Patent Application Publication No. 2006-237151

In the wiring substrate of the structure described above, a position of the wiring pattern (connection part) exposed to the surface is determined by the position of the protrusion part. Position information about the protrusion part and the wiring pattern is required in the case of performing alignment at the time of mounting. As its technique, it is contemplated to form a wiring pattern (alignment mark) for alignment on a surface of a protrusion part together with wiring patterns other than the wiring pattern for alignment, and expose its surface from an insulating layer. However, in the case where a material of the protrusion part is the same material as the insulating layer with which the surface of the wiring pattern is covered, or the case where the boundary between the protrusion part and the insulating layer cannot be recognized clearly, etc., the position of the protrusion part cannot be properly checked. Therefore, there is a problem peculiar to the wiring substrate as described above in which a position relation between the protrusion part and the wiring pattern (connection part) exposed from the surface of the insulating layer cannot be checked accurately and it becomes difficult to mount a chip etc.

### SUMMARY

Exemplary embodiments of the present invention provides a wiring substrate manufacturing method for a wiring substrate which is capable of accurately producing the position where the wiring pattern is formed with respect to a position of the protrusion part and capable of accurately grasping a position of a pad (wiring pattern) and performing mounting with high accuracy when flip chip mounting etc. of a semiconductor component are performed on the wiring substrate.

The exemplary embodiments of the present invention are as described below.

According to a first aspect of the invention, a wiring substrate comprises a substrate, a protrusion part made of an insulator and formed on a surface of the substrate, a wiring pattern formed on the surface of a substrate, and an insulating layer covering the surface of the substrate, wherein the wiring pattern at least partially extends on a top part of the protrusion part, and a surface of a connection part of the wiring pattern formed on the top part of the protrusion part is exposed from the surface of the insulating layer. The wiring substrate further comprises a pedestal for mark or a pedestal for providing a mark formed on the surface of the substrate, whose top part is formed in a rectangular or circular plane shape, and an alignment mark formed on the top part of the pedestal for mark. The alignment mark is formed in a shape in which a length of a horizontal direction and a length of a vertical direction are respectively longer than a length of a horizontal direction and a length of a vertical direction of the top part of the pedestal for mark and a shape in which an area present in the top part of the pedestal for mark is smaller than an area of the top part of the pedestal for mark. A surface of an upper surface part of the alignment mark is exposed from the surface of the insulating layer.

According to a second aspect of the invention, in the above-mentioned wiring substrate, a part of the protrusion part is formed as a pedestal for mark comprising a top part of a rectangular or circular plane shape, and a part of the wiring pattern is formed as an alignment mark comprising a shape in which a length of a horizontal direction and a length of a vertical direction are respectively longer than a length of a horizontal direction and a length of a vertical direction of the top part of the pedestal for mark and a shape in which an area present in the top part of the pedestal for mark is smaller than an area of the top part of the pedestal for mark and is disposed on the top part of the pedestal for mark and also a surface of its upper surface part is exposed from the surface of the insulating layer.

According to a third aspect of the invention, the alignment mark is made of a sector shape or a shape in which plural rectangles are combined. Further, according to a fourth aspect of the invention, the alignment mark is preferable to be made of a T shape, an L shape or a cross shape.

According to a fifth aspect of the invention, a manufacturing method of a wiring substrate comprises the steps of forming a pedestal for mark and a protrusion part made of an insulator on a surface of a substrate, forming a wiring pattern on the surface of the substrate with wiring extended to a top part of the protrusion part and simultaneously forming an alignment mark on a top part of the pedestal for mark, covering the surface of the substrate on which the wiring pattern and the alignment mark are formed with an insulating layer, and exposing a surface of an upper surface part of the alignment mark and a surface of a connection part of the wiring pattern formed so as to extend on the top part of the protrusion part from the insulating layer.

Also, according to a sixth aspect of the invention, the pedestal for mark comprises a top part of a rectangular or circular plane shape, and the alignment mark comprises a shape in which a length of a horizontal direction and a length of a vertical direction are respectively longer than a length of a horizontal direction and a length of a vertical direction of the top part of the pedestal for mark and a shape in which an area present in the top part of the pedestal for mark is smaller than an area of the top part of the pedestal for mark.

According to the first and second aspects of the invention, it is possible to accurately see in what position a wiring pattern, which is formed on a surface of a wiring substrate forming a lower layer and in which only a surface of a connection part is exposed from an insulating layer on the wiring substrate, is formed with respect to a position of a protrusion part on the same wiring substrate. As a result of that, when a semiconductor component etc. are mounted on the wiring substrate by flip chip bonding or wire bonding, a position of a pad (wiring pattern) can accurately be grasped to mount the semiconductor component etc. with high accuracy.

According to the third and fourth aspects and other aspects of the invention, it can accurately and easily be recognized how a wiring pattern deviates from a predetermined position in a horizontal direction and a vertical direction with respect to a protrusion part.

According to the fifth and sixth aspects of the invention, on a wiring substrate, a part of the protrusion part is formed as a pedestal for mark comprising a top part of a rectangular or circular plane shape. A part of the wiring pattern is formed as an alignment mark comprising a shape in which a length of a horizontal direction and a length of a vertical direction are respectively longer than a length of a horizontal direction and a length of a vertical direction of the top part of the pedestal for mark and a shape in which an area present in the top part of the pedestal for mark is smaller than an area of the top part b of the pedestal for mark. In this case, they are formed simultaneously in the same step, so that it can accurately be seen what position the wiring pattern is formed with respect to a position of the protrusion part based on a position of the alignment mark.

Other features and advantages may be apparent from the following detailed description, the accompanying drawings and the claims.

### BRIEF DESCRIPTION OF THE DRAWINGS

These and other advantages including a full and enabling disclosure of the present invention, including the best mode thereof, to one of ordinary skill in the art, is set forth more particularly in the remainder of the specification, including reference to the accompanying figures. Therein:

Figs. 1A and 1B are explanatory diagrams of a step in a manufacturing method of a wiring substrate according to an embodiment of the invention.

Figs. 2A to 2E are explanatory diagrams of a step in the manufacturing method of the wiring substrate according to an embodiment of the invention.

Figs. 3A and 3B are explanatory diagrams of a step in the manufacturing method of the wiring substrate according to an embodiment of the invention.

Figs. 4A to 4C are plan diagrams explaining the manufacturing method of the wiring substrate according to an embodiment of the invention.

Fig. 5 is a schematic diagram of the wiring substrate according to an embodiment of the invention.

Fig. 6 is a schematic diagram explaining an effect of the invention.

Fig. 7 is a schematic diagram explaining the effect of the invention.

Figs. 8A to 8E are schematic diagrams showing other examples of alignment marks and pedestals for mark of the wiring substrate according to the embodiment of the invention.

Figs. 9A to 9C are schematic diagrams showing other examples of alignment marks and pedestals for mark of the wiring substrate according to the embodiment of the invention.

Fig. 10 is a schematic diagram showing one example of a wiring substrate according to a related-art embodiment.

### DETAILED DESCRIPTION

Reference will now be made in detail to various embodiments, one or more examples of which are illustrated in the figures. Each example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations. The examples are described using specific language which should not be construed as limiting the scope of the appending claims. The drawings are not scaled and are for illustrative purposes only.

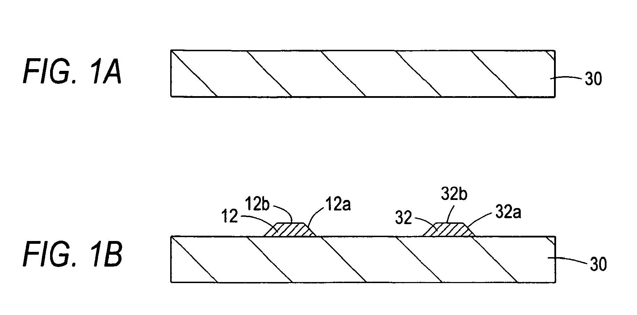

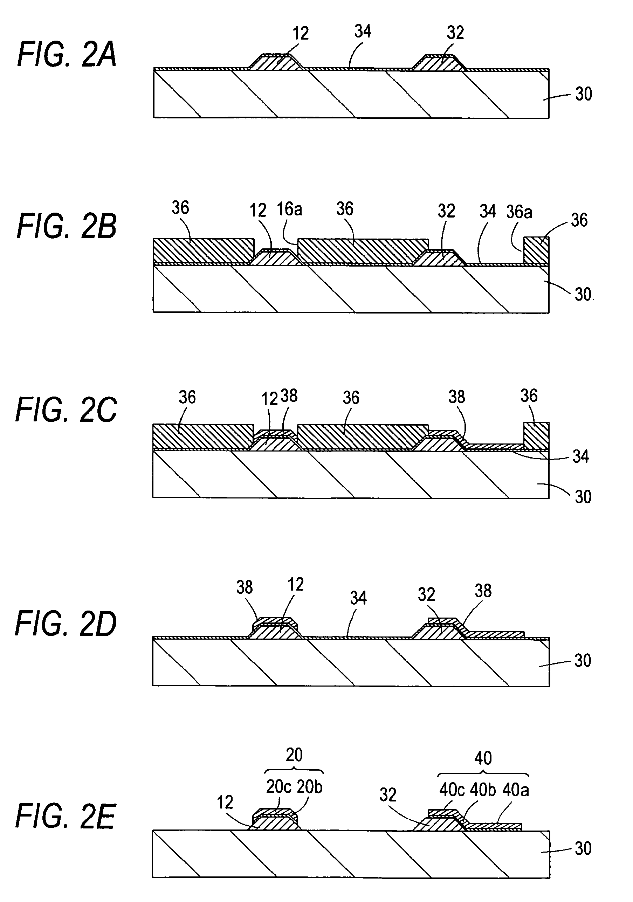

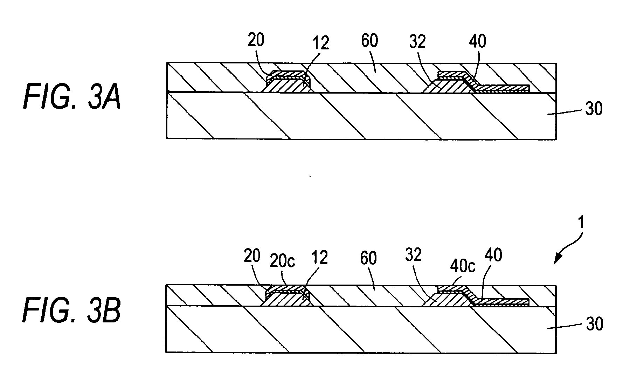

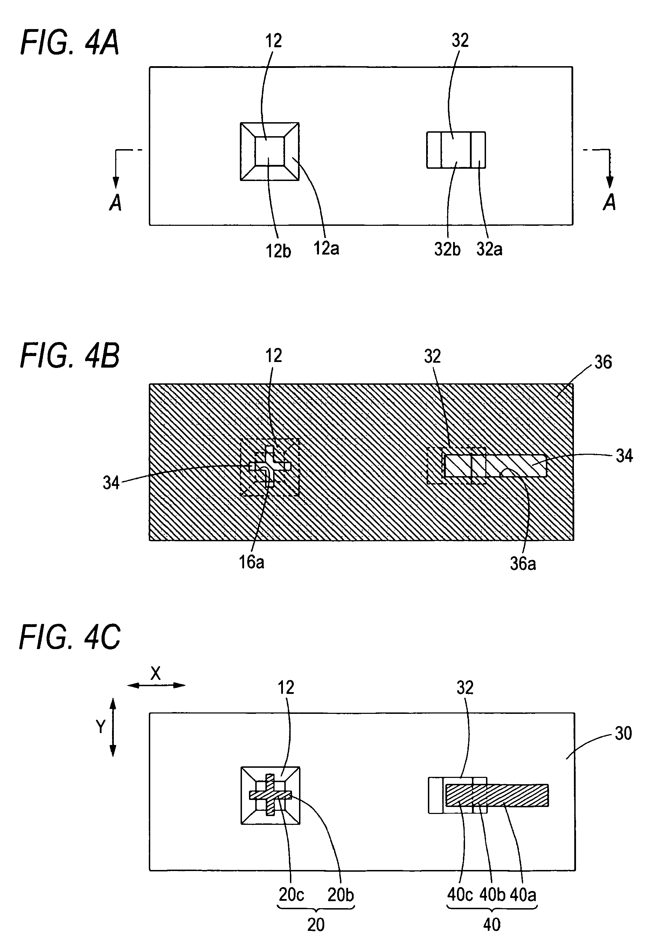

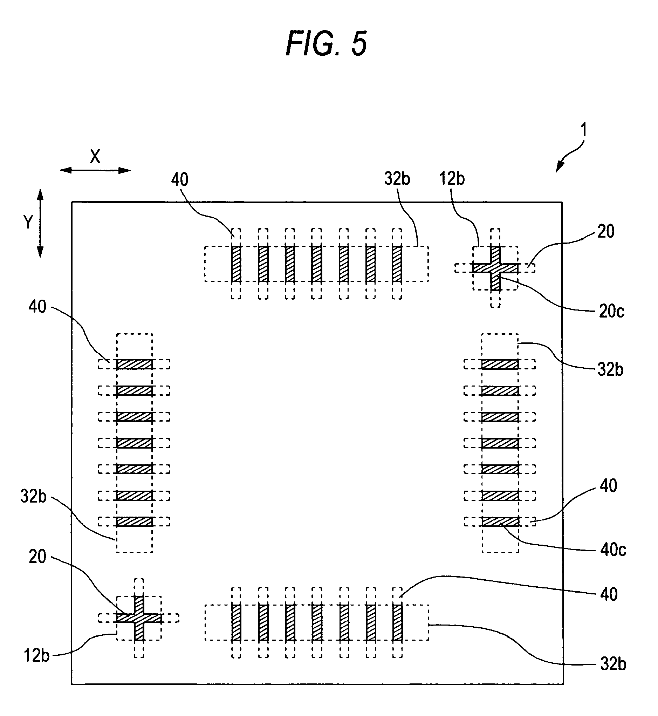

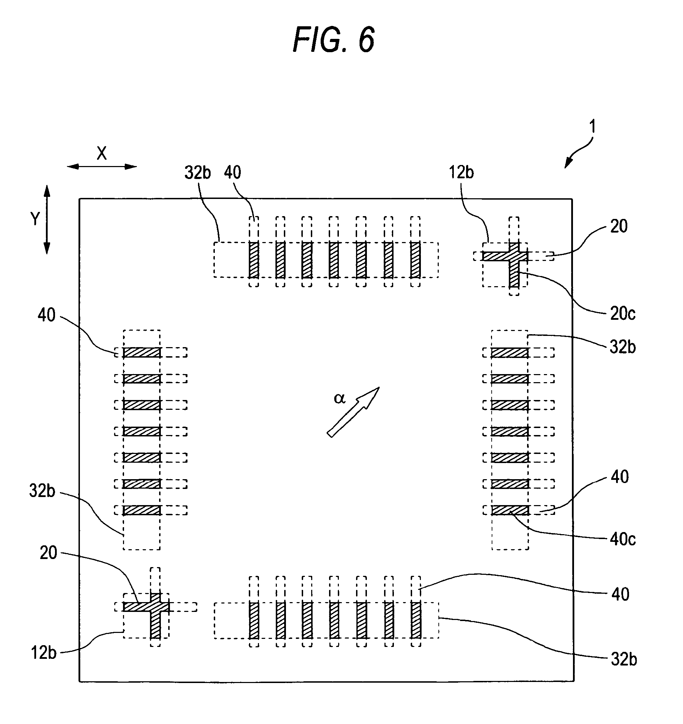

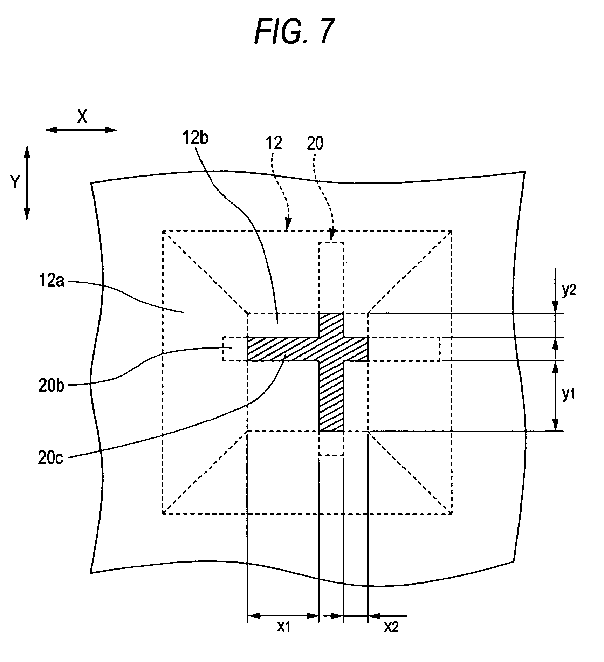

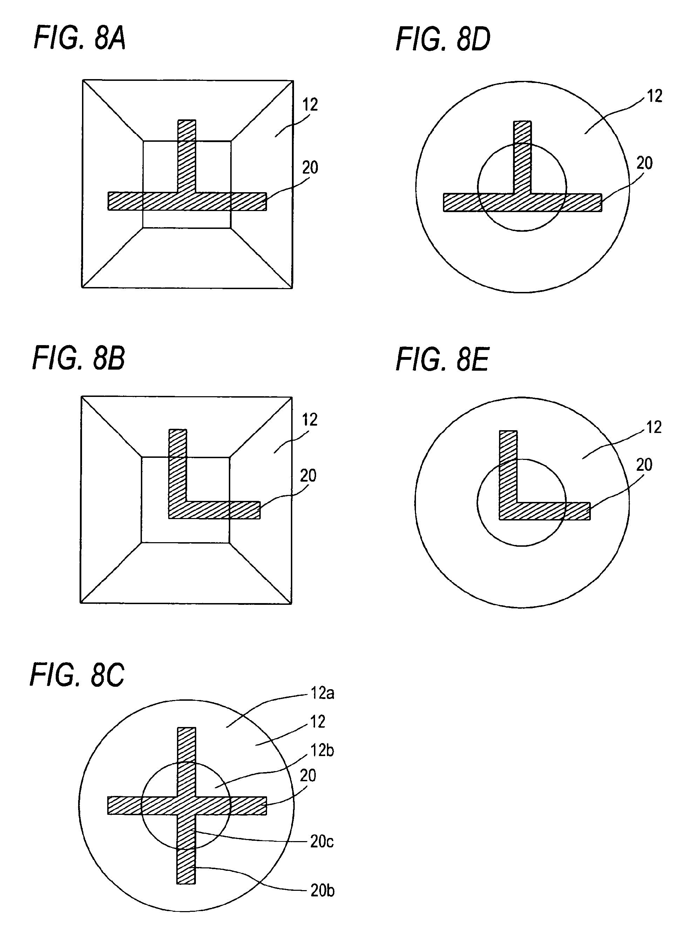

An embodiment of the invention will hereinafter be described in detail with reference to the drawings. Figs. 1A and 1B are explanatory diagrams of a step of forming a protrusion part 32 and a pedestal 12 for providing a mark in a manufacturing method of a wiring substrate 1 according to an embodiment of the invention. Also, Figs. 2A to 2E are explanatory diagrams of a step of forming a wiring pattern 40 and an alignment mark 20 in the manufacturing method of the wiring substrate 1 according to an embodiment of the invention. Figs. 3A and 3B are explanatory diagrams of a step of forming an insulating layer 60 on a wiring substrate 30 in the manufacturing method of the wiring substrate 1 according to an embodiment of the invention and exposing a connection part 40c of the wiring pattern 40 and an upper surface part 20c of the alignment mark 20 from the insulating layer 60. Figs. 4A to 4C are plan diagrams explaining the manufacturing method of the wiring substrate 1 according to an embodiment of the invention. Fig. 5 is a schematic diagram of the wiring substrate 1 according to an embodiment of the invention. Figs. 6 and 7 are schematic diagrams explaining an effect of the invention. Figs. 8A to 9C are schematic diagrams showing other examples of alignment marks 20 and pedestals 12 for mark of the wiring substrate 1 according to the embodiment of the invention. In addition, with numeral of the drawings, numeral 40 is used as generic names of numerals 40a, 40b, ... (the same applies to other numerals).

The manufacturing method of a wiring substrate according to an embodiment of the invention will be described using Figs. 1A to 4C. In addition, respective diagrams in Figs. 1A to 3B are sectional diagrams of a substrate in each step.

First, a step of forming a protrusion part 32 and a pedestal 12 for providing a mark is shown in Figs. 1A and 1B.

Fig. 1A shows a wiring substrate 30 on which a wiring pattern and an alignment mark are formed. A resin substrate made of a material such as a glass epoxy or a filler-containing epoxy can be used as the wiring substrate 30. The wiring substrate 30 normally comprises plural wiring layers. In order to electrically conduct these wiring layers, a plated through hole or a via hole is formed. In the drawings, these configurations are omitted.

Fig. 1B shows a state of forming the protrusion part 32 and the pedestal 12 for providing one or more marks on a surface of the wiring substrate 30. The protrusion part 32 is aligned with a plane arrangement position of electrically connecting wiring patterns between layers. The protrusion part 32 is formed by an insulator so as to become higher than a thickness of the wiring pattern formed on the surface of the wiring substrate 30. Also, the pedestal 12 for mark is formed in the same height as that of the protrusion part 32 by an insulator, for example. In addition, both of the protrusion part 32 and the pedestal mark 12 can have a trapezoid shape when seen in cross section in the embodiment.

Fig. 4A shows a plan view on the wiring substrate 30 in a state of forming the protrusion part 32 and the pedestal 12 on the surface of the wiring substrate 30 (Fig. 1B is a sectional diagram taken on line A-A of Fig. 4A). In this embodiment, in the protrusion part 32, the plane shape is formed in a rectangle and the side surface 32a is formed as an inclined surface with respect to the surface of the wiring substrate 30 and the top part 32b is formed as a flat surface. The wiring pattern is formed so as to extend partially to the top part 32b and the side surface 32a. It is normally preferable to form the width of the protrusion part 32 slightly wider than the pattern width of the wiring pattern.

On the other hand, the side surface 12a of the pedestal 12 is formed as an inclined surface with respect to the surface of the wiring substrate 30 and the top part 12b is formed to have a rectangular plane shape as shown in Fig. 4A. In addition, the shape of the lower portion or the footprint of the pedestal 12 facing the wiring substrate may be of rectangular shape or of circular shape (the rectangular shape in the embodiment).

Further, as another example of the pedestal 12 for forming or providing a mark, the top part 12b may be formed in a circular plane shape as shown in Figs. 8C to 8E.

As a method for forming the protrusion part 32 and the pedestal 12 for mark, a formation method by a printing method such as screen printing using a pasty resin, a formation method for transferring a resin formed on a peeling sheet in a predetermined position to the wiring substrate 30, a formation method for spraying a resin on the wiring substrate 30 by an ink jet, a formation method for dispensing a resin, etc. can be used. The printing method or the transferring method are particularly effective since the protrusion part 32 and the pedestal 12 for mark can be efficiently formed on large-sized work pieces or substrates.

Also, the protrusion part 32 and the pedestal 12 are formed so as to be swollen up them on the surface of the wiring substrate 30 by an imprint method. An imprint mold used herein is a mold in which a region for forming the protrusion part 32 and the pedestal 12 is formed in a recessed part, and by pressing the imprint mold on the surface of the wiring substrate 30 after a proper amount of resin is supplied to the surface of the wiring substrate 30, the surface of the wiring substrate 30 is plastically deformed and the protrusion part 32 and the pedestal 12 for mark can be formed. The thickness of a wiring pattern is about 10 µm and the protrusion part 32 formed on the surface of the wiring substrate 30 could be formed in a height of about 20 to 30 µm, so that it is easy to be formed by the printing method or the imprint method. At this time, the pedestal 12 for mark could be formed in the same height as that of the protrusion part 32.

Subsequently, Figs. 2A to 2E show a step of forming a wiring pattern 40 and an alignment mark 20.

Fig. 2A shows a state of forming a plated seed layer 34 on a surface of a work piece or the wiring substrate 30 after the protrusion part 32 and the pedestal 12 for mark are formed on the surface of the wiring substrate 30. The plated seed layer is formed by, for example, a sputtering method or a method for performing electroless copper plating on the substrate surface or the surface of the work piece. The plated seed layer is a layer used as a power feeding layer in the case of electrolytic plating and could be formed in a thickness necessary for plating power feeding.

The next Fig. 2B shows a state of forming a resist pattern 36 on the surface of the work piece according to a pattern shape of a wiring pattern and an alignment mark formed on the surface of the wiring substrate 30. In the resist pattern 36, a resist film is deposited on the surface of the work piece and a pattern formation is performed so as to expose regions forming the wiring pattern and the alignment mark on the plated seed layer 34 by light exposure and development. Fig. 4B shows a plan view on the substrate in a state of forming the resist pattern 36 on the surface of the wiring substrate 30. The regions, in which the wiring pattern and the alignment mark are formed, of the surface of the work piece or substrate are respectively formed in exposure holes 36a and 16a in which the plated seed layer 34 is exposed at the bottom of the exposure holes 36a. The exposure hole 36a is formed so as to communicate (continue) from the surface of the wiring substrate 30 toward the side surface 32a and the top part 32b of the protrusion part 32. On the other hand, the exposure hole 16a is formed so as to continue from the side surface 12a of the pedestal 12 for marking toward the top part 12b, for example. In addition, the exposure hole 16a may be formed so as to continue from the surface of the wiring substrate 30 toward the side surface 12a and the top part 12b of the pedestal 12 for marking in a manner similar to the exposure hole 36a.

Fig. 2C shows a state of forming copper plating 38 on a surface of the plated seed layer 34 within the exposure holes 36a, 16a by performing electrolytic copper plating to the work piece using the plated seed layer 34 as a plated power feeding layer. After the electrolytic copper plating is performed, the resist pattern 36 is removed (Fig. 2D) to expose portions or regions of the plated seed layer 34 at the surface of the work piece, which portions or regions are then selectively removed (Fig. 2E). Since the plated seed layer 34 is much thinner than the copper plating 38, the regions, which are covered neither by the copper plating 38 nor by the resist, are exposed portions of the plated seed layer 34, which can be selectively removed using an etching liquid for etching copper. By removing the exposed portion of the plated seed layer 34, the wiring pattern 40 and the alignment mark 20 remain on the wiring substrate 30 as an independent or separate pattern.

Fig. 4C shows a plan view on the substrate in a state of forming the wiring pattern 40 and the alignment mark 20 on the wiring substrate 30. The wiring pattern 40 comprises a region 40a deposited on the surface of the wiring substrate 30, a conduction part 40b deposited on the side surface of the protrusion part 32, and a connection part 40c deposited on the top part 32b of the protrusion part 32. That is, the wiring pattern 40 is formed with wiring extended from the routed portion deposited on the surface of the wiring substrate 30 to the top part 32b of the protrusion part 32, and the connection part 40c of the wiring pattern 40 is supported in a position higher than the surface of the wiring substrate 30.

On the other hand, the alignment mark 20 comprises a side edge part 20b deposited on the side surface of the pedestal 12 for mark, and an upper surface part 20c deposited on the top part 12b of the pedestal 12 for mark. In this case, the alignment mark 20 is formed in a shape in which a length of a horizontal direction and a length of a vertical direction are respectively longer than a length of a horizontal direction and a length of a vertical direction of the top part 12b of the pedestal 12 for mark and a shape in which an area present in the top part 12b of the pedestal 12 for mark is smaller than an area of the top part 12b of the pedestal 12 for mark as shown in Fig. 4C. In other words, the alignment mark extends beyond the area of the top part 12b but does not assume the total area of the top part 12b of the pedestal 12. In addition, the alignment mark 20 may be configured to extend from the side edge part 20b to the surface of the wiring substrate 30 in a manner similar to the wiring pattern 40.

Here, the "horizontal direction" in the present application is defined as referring to a direction (direction shown by X in the diagram) along one side formed in a horizontal direction of the wiring substrate 30 (or the wiring substrate 1) and the "vertical direction" is defined as referring to a direction (direction shown by Y in the diagram) orthogonal to the horizontal direction as shown in Figs. 4A to 7. In addition, when the wiring substrate 30 has a shape other than a rectangle, the "horizontal direction" and the "vertical direction" could properly be set as orthogonal coordinates.

Subsequently, Figs. 3A and 3B show a step of forming an insulating layer 60 on the wiring substrate 30 and exposing the connection part 40c of the wiring pattern 40 and the upper surface part 20c of the alignment mark 20 from the insulating layer 60. Fig. 3A shows a state of forming the insulating layer 60 so that the wiring pattern 40 and the alignment mark 20 formed on the surface and the connection part 40c deposited on the top part 32b of the protrusion part 32 and the upper surface part 20c deposited on the top part 12b of the pedestal 12 for mark are respectively buried. The insulating layer 60 can be formed by a method for providing an insulating film on a surface of a work piece or a method for coating a surface of a work piece with an insulating material.

Fig. 3B shows a state of exposing a surface of the connection part 40c of the wiring pattern 40 deposited on the top part 32b of the protrusion part 32 and a surface of the upper surface part 20c of the alignment mark 20 deposited on the top part 12b of the pedestal 12 from the insulating layer 60. Here, as a method for exposing the connection part 40c and the upper surface part 20c from the insulating layer 60, a method for performing dry etching, a method for surface polishing, a sand blast method for spraying abrasive grains and removing a necessary region, etc. can be used. Also, by laser machining, the insulating resin with which the top part 32b of the protrusion part 32 and the top part 12b of the pedestal 12 for mark are covered can be removed to expose the connection part 40c of the wiring pattern 40 and the upper surface part 20c of the alignment mark 20. Also, when an insulating resin forming the insulating layer 60 is made of a photosensitive resin material, by light exposure and development operations, the insulating resin with which the top part 32b of the protrusion part 32 and the top part 12b of the pedestal 12 for mark are covered can be removed to expose the surfaces of the connection part 40c and the upper surface part 20c.

As described above, the wiring substrate according to the invention manufactured through the manufacturing steps described above as one example has the following configuration. The surface of the connection part 40c of the wiring pattern 40 formed on the top part 32b of the protrusion part 32 is exposed from the surface of the insulating layer 60 which covers the wiring substrate 30. The pedestal 12 for mark whose top part 12b is formed in a rectangular or circular plane shape is formed on the wiring substrate 30. The alignment mark 20 is formed on the top part 12b of the pedestal 12 for mark. The alignment mark 20 is formed in a shape in which a length of a horizontal direction and a length of a vertical direction are respectively longer than a length of a horizontal direction and a length of a vertical direction of the top part 12b of the pedestal 12 for mark. The alignment mark 20 is also formed in a shape in which an area present in the top part 12b of the pedestal 12 for mark is smaller than an area of the top part 12b of the pedestal 12 for mark. The surface of the upper surface part 20c of the alignment mark 20 is exposed from the surface of the insulating layer 60.

By this configuration, it is possible to see or recognize the position of the wiring pattern 40 with respect to the protrusion part 32 by recognizing a surface shape of the upper surface part 20c of the alignment mark 20 exposed from the surface of the insulating layer 60 by image processing etc. That is, it can be seen how the wiring pattern 40 deviates from a predetermined position in the horizontal direction and the vertical direction with respect to the protrusion part 32. Fig. 6 shows the case where the wiring pattern 40 (and the alignment mark 20) deviate in a direction of α.

Also, it is preferable that the alignment mark 20 be made of a T shape, an L shape or a cross shape in order to achieve the effect described above more remarkably. That is because it can accurately and easily be recognized how the wiring pattern 40 deviates from the predetermined position in the horizontal direction and the vertical direction with respect to the protrusion part 32. More particularly, the amount of deviation of the wiring pattern 40 from the protrusion part 32 can accurately and easily be checked by calculating differences between x₁-x₂ and y₁-y₂ of the exposed wiring by the image processing etc. as shown in Fig. 7. Here, other embodiments of the alignment mark 20 are shown in Figs. 8A to 8E. In addition, Figs. 8A and 8B are examples of the case where a shape of the top part 12b of the pedestal 12 for mark is a rectangle, and Figs. 8C to 8E are examples of the case where the shape is a circle.

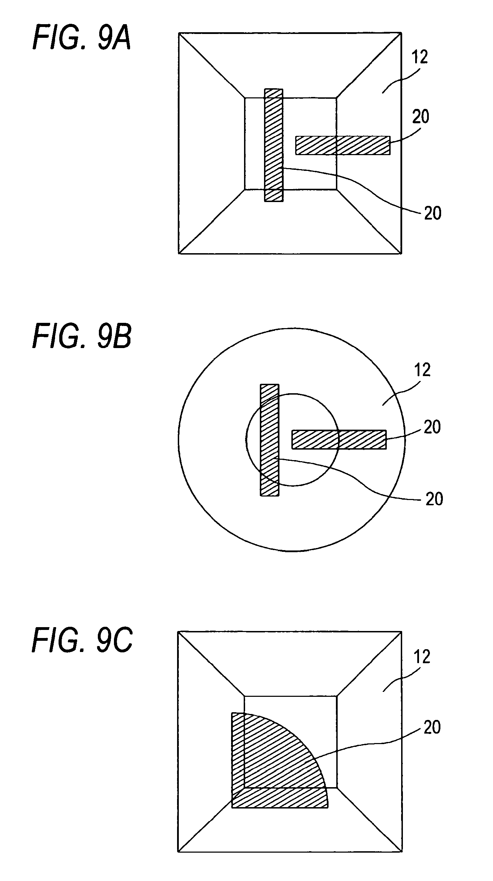

Also, it can be recognized how the wiring pattern 40 deviates from a predetermined position in the horizontal direction and the vertical direction with respect to the protrusion part 32 when the alignment mark 20 has shapes (Figs. 9A and 9B) in which plural rectangles are combined or a sector shape (Fig. 9C) as shown in Figs. 9A to 9C.

Also, according to the manufacturing method of the wiring substrate according to the invention, a part of the protrusion part 32 is formed as the pedestal 12 for mark comprising a top part of a rectangular or circular plane shape. Further, a part of the wiring pattern 40 is formed as the alignment mark 20 comprising a shape in which a length of a horizontal direction and a length of a vertical direction are respectively longer than a length of a horizontal direction and a length of a vertical direction of the top part 12b of the pedestal 12 for mark and a shape in which an area present in the top part 12b of the pedestal 12 for mark is smaller than an area of the top part 12b of the pedestal 12 for mark. In this case, they are formed simultaneously in the same step, so that it can accurately be seen what position the wiring pattern 40 is formed with respect to a position of the protrusion part 32 based on a position of the alignment mark 20.

However, an effect similar to that described above can be produced even when their formation methods are not the same (for example, a method for forming the alignment mark 20 by resin while forming the wiring pattern 40 by metal is contemplated).

By the way, the number of alignment marks 20 formed on the wiring substrate 30 is not particularly limited, and the alignment marks 20 are disposed in two places diagonal in the substrate as one example (see Fig. 5). In addition, when plural alignment marks 20 are disposed, the marks not necessarily have the same shape.

According to the wiring substrate and the manufacturing method of the wiring substrate according to the invention as described above, it can accurately be seen in what position the wiring pattern is formed with respect to a position of the protrusion part. As a result of that, when a semiconductor component etc. are mounted on the wiring substrate by flip chip bonding or wire bonding, a position of a pad (wiring pattern) can accurately be identified to mount the semiconductor component etc. with high accuracy. That is, a semiconductor apparatus etc. with high quality are provided and a defective rate resulting from poor bonding can be reduced. In addition, of course, it is similarly effective in the case of forming a multilayer wiring substrate.

Particularly, the invention provides effective means for solving a problem peculiar to a wiring substrate in which a protrusion part and a wiring pattern are formed on a surface of the wiring substrate with the wiring pattern extending on a top part of the protrusion part and a surface on which the wiring pattern of the substrate is formed is covered with an insulating layer and a surface of a connection part of the wiring pattern formed on the top part of the protrusion part is formed with the surface of the connection part exposed from a surface of the insulating layer.

Furthermore, in the case of forming a wiring pattern on four sides (the same applies to the case of three sides or two sides orthogonal) of the periphery in a peripheral shape in the wiring substrate, detection of a position of the wiring pattern and a position of a protrusion part is required with higher accuracy, so that the invention especially exerts a remarkable effect in such a case.

In addition, the manufacturing method of the wiring substrate according to the invention has been described by taking a semi-additive method as an example, but is not limited to this method and can also be applied to the case by a subtractive method etc.

Also, the wiring substrate according to the invention can be used for wire bonding mounting as well as flip chip mounting. Also, the wiring substrate can be used as a multilayer wiring substrate by stack.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. A wiring substrate comprising:
a substrate (30);
a protrusion part (32) made of an insulator and formed on a surface of the substrate (30);
a wiring pattern (40) formed on the surface of the substrate (30), the wiring pattern (40) extending on a top part (32b) of the protrusion part (32);
a pedestal (12) for providing a mark formed on the surface of the substrate (30), whose top part (12b) is formed in a rectangular or circular plane shape;
an alignment mark (20) formed on the top part (12b) of the pedestal (12), the alignment mark (20) being formed in a shape in which a length of a horizontal direction and a length of a vertical direction are respectively longer than a length of a horizontal direction and a length of a vertical direction of the top part (12b) of the pedestal (12) and a shape in which an area present in the top part (12b) of the pedestal (12) is smaller than an area of the top part (12b) of the pedestal (12); and
an insulating layer (60) covering the surface of the substrate (30),
wherein a surface of a connection part (40c) of the wiring pattern (40) formed on the top part (32b) of the protrusion part (32) is exposed from a surface of the insulating layer (60), and a surface of an upper surface part of the alignment mark (20) is exposed from the surface of the insulating layer (60).

2. A wiring substrate as claimed in claim 1, wherein the alignment mark (20) is made of a sector shape or a shape in which plural rectangles are combined.

3. A wiring substrate as claimed in claim 1, wherein the alignment mark (20) is made of a T shape, an L shape or a cross shape.

4. A manufacturing method of a wiring substrate, comprising steps of:
forming a pedestal (12) for providing a mark and a protrusion part (32) made of an insulator on a surface of a substrate (30);
forming a wiring pattern (40) on the surface of the substrate (30) with the wiring pattern (40) at least partially extending to a top part (32b) of the protrusion part (32), and forming an alignment mark (20) on a top part (12b) of the pedestal (12);
covering the surface of the substrate (30) with an insulating layer (60); and
exposing a surface of an upper surface part of the alignment mark (20) and a surface of a connection part (40c) of the wiring pattern (40) formed so as to extend on the top part (32b) of the protrusion part (32) from the insulating layer (60).

5. A manufacturing method of a wiring substrate as claimed in claim 4, wherein the top part (12b) of the pedestal (12) comprises a rectangular or circular plane shape, and the alignment mark (20) comprises a shape in which a length of a horizontal direction and a length of a vertical direction are respectively longer than a length of a horizontal direction and a length of a vertical direction of the top part (12b) of the pedestal (12) and a shape in which an area present in the top part (12b) of the pedestal (12) is smaller than an area of the top part (12b) of the pedestal (12).

6. A wiring substrate comprising:
a substrate (30) comprising a surface;
a protrusion part (32) arranged on the surface of the substrate (30) and comprised of an insulator material, the protrusion part (32) comprising a top part (32b) which is disposed in spaced relation to the surface of the substrate (30);
a wiring pattern (40) formed on the surface of the substrate (30), the wiring pattern (40) comprising a connection part (40c) arranged on the top part (32b) of the protrusion part (32);
a pedestal (12) arranged on the surface of the substrate (30) and comprising a top part (12b) which is disposed in spaced relation to the surface of the substrate (30) and which is of rectangular or circular plane shape;
an alignment mark (20) disposed on the top part (12b) of the pedestal (12), the alignment mark (20) having a given shape with a given vertical and a given horizontal extension parallel to the surface of the substrate (30), wherein the vertical and horizontal extensions of the alignment mark (20) are respectively longer than the horizontal and vertical extension of the top part (12b) of the pedestal (12), and wherein the area of the top part (12b), which is covered by the alignment mark (20), is smaller than the total area of the top part (12b) of the pedestal (12); and
an insulating layer (60) covering the surface of the substrate (30), wherein the surface of the connection part (40c) of the wiring pattern (40) and at least upper portions of the surface of the alignment mark (20) are exposed from the insulating layer (60).
